# EUROPEAN PATENT APPLICATION

(11) **EP 4 617 690 A1**
(43) Date of publication of application: **17.09.2025**
(21) Application number: 23928279.1
(22) Date of filing: 29.08.2023
(51) Int. Cl.: G01R 31/385, G01R 31/387, G01R 31/392

(54) **METHOD FOR ACTIVELY DETECTING FAULT IN ENERGY STORAGE SYSTEM, AND ENERGY STORAGE SYSTEM**

(30) Priority: 20.03.2023 CN 202310287764
(71) Applicant: Hefei Gotion High-Tech Power Energy Co., Ltd., Hefei, Anhui 230012 (CN)
(72) Inventor: LU, Kai, Hefei, Anhui 230012 (CN); CHEN, Xiaohu, Hefei, Anhui 230012 (CN); CHENG, Qianqian, Hefei, Anhui 230012 (CN)
(74) Representative: Novagraaf Technologies
(86) International application number: PCT/CN2023/115575
(87) International publication number: WO 2024/192974

(57) **Abstract**

An active fault detection method of an energy storage system, and the energy storage system are provided. The active fault detection method of the energy storage system includes: a step of causing the state of charge of an energy storage battery to reach a first preset value; a discharge time acquisition step of causing the energy storage battery to discharge at constant current a until the state of charge thereof reaches a second preset value, stopping discharging, and acquiring a discharge time T, wherein the second preset value is less than the first preset value; and judging whether the discharge time T is less than or equal to a preset discharge time t, if so, judging that the energy storage battery has a hidden fault or the service life thereof is seriously shortened, and if not, judging that the energy storage battery is normal. The active fault detection method of the energy storage system may judge whether the energy storage battery has the hidden fault or whether the service life of the energy storage battery seriously shortened.

## Description

The present invention claims the priority of Chinese Patent Application 2023102877642, filed in the State Intellectual Property Office of China on March 20, 2023, and entitled "Active Fault Detection Method of Energy Storage System, and Energy Storage System".

### Technical Field

The present invention relates to the technical field of energy storage batteries, and in particular to an active fault detection method of an energy storage system, and the energy storage system.

### Background

A micro-grid is the most main application field of an energy storage system, and the functions of the energy storage system in the micro-grid include: 1) improving the stability of distributed energy resources, for example, solar energy, wind energy, and the like, wherein the power generation capacities of the distributed energy resources have randomness due to the influence of external environments such as illumination and wind speed, and the energy storage system is able to balance the fluctuation of the distributed energy resources in the micro-grid, so as to stabilize the output; 2) improving the quality of electric energy used by users, wherein in the case of grid-connected operation with various networks, the quality of the electric energy of the micro-grid must meet national standards, a power factor, voltage imbalance, voltage flicker and other parameters must reach standard values, and the energy storage system may quickly provide a power buffer and provide active and reactive power supports to stabilize voltage fluctuation; and 3) performing peak regulation and frequency modulation, wherein energy storage in the micro-grid may be that excess electric energy emitted from the distributed energy resources is absorbed in the case of valley and the electric energy is released at a load peak, thereby reducing the operation and maintenance pressure of a power grid. Therefore, the energy storage system needs to be powered on for operation for a long time, however, as the number of times of charging and discharging the energy storage system increases, the service life thereof is shortened, and the problems of internal faults and battery consistency are increasingly prominent, and the energy storage system cannot be moved after running on a project site, and thus it is difficult to check the reliability thereof.

In a battery fault diagnosis method in a battery pack known to the inventors, fault diagnosis is performed on the battery pack according to remote monitoring data (storage data) after the battery pack is subjected to multiple times of charging, and working-condition discharging operation and after a fault occurs. Specifically, overall diagnosis is performed on the battery pack by a maximum voltage value Vmax and a minimum voltage value Vmin of a battery pack series module, so as to screen out a faulty battery pack.

According to the above method, after a fault occurs in the battery pack, the faulty battery is screened out according to the storage data, no matter for a power battery or an energy storage battery, the risk in a charging and discharging state much higher than the risk in a static state, but the diagnosis method in the static state cannot play a fault prediction role, may only recognize the faulty battery after the fault occurring in the charging and discharging process of the battery pack appears, but cannot initiatively recognize and diagnose the fault if the battery fault remains latent.

In the prior art, at the beginning of production or after running for a period of time, there may be problems of poor welding or poor battery manufacturing process inside or outside the majority of batteries, for example, external insufficient welding or an internal fault of a single battery, the energy storage system may still normally operate in the presence of the above fault under conventional charging and discharging conditions (constant-current charging and discharging), that is, the fault is elusive to manifest (i.e., the energy storage battery has a hidden fault), and the fault manifests or the service life of the energy storage battery is seriously shortened after vibration such as transportation over a period of time, or operation. However, the method known by the inventors may only recognize the fault only after the fault occurs in the energy storage battery and manifest, but cannot actively recognize and diagnose the fault if the fault of the energy storage battery does not manifest, and moreover, it is difficult to discover the latent fault, resulting in a fault of the entire energy storage system easily.

### Summary

The main objective of the present invention is to provide an active fault detection method of an energy storage system, and the energy storage system. The active fault detection method of the energy storage system may judge whether an energy storage battery has a latent fault or whether the service life thereof is seriously shortened.

In order to achieve the above objective, some embodiments of the present invention provide an active fault detection method of an energy storage system, including: a step of causing a state of charge of an energy storage battery to reach a first preset value; a discharge time acquisition step of causing the energy storage battery to discharge at constant current a until the state of charge thereof reaches a second preset value, stopping discharging, and acquiring a discharge time T, wherein the second preset value is less than the first preset value; and judging whether the discharge time T is less than or equal to a preset discharge time t, if so, judging that the energy storage battery has a hidden fault or a service life thereof is seriously shortened, and if not, judging that the energy storage battery is normal.

Further, the energy storage battery includes a plurality of battery cells, a serial number of each of the plurality of battery cells is i, i may be 1 to n, n is an integer greater than 1, and the active fault detection method of the energy storage system further includes: after judging that the energy storage battery has the hidden fault or the service life thereof is seriously shortened, acquiring a voltage Vi of the each of the plurality of battery cells i at a moment of stopping discharging; respectively judging whether each voltage Vi is less than or equal to a sum of a cut-off discharge voltage and a voltage fluctuation value of the energy storage battery, if so, judging that a battery cell i in the plurality of battery cells is abnormal and replacing the battery cell i, and if not, judging that the battery cell i has no fault.

Further, the discharge time acquisition step includes: a discharging step of discharging the energy storage battery at the constant current a by using an energy storage converter, and recording an initial moment T1; and judging whether the state of charge of the energy storage battery is less than or equal to the second preset value, if so, controlling the energy storage battery to stop discharging by using the energy storage converter and recording a cut-off moment T2, and if not, continuing to execute the discharging step, wherein the discharge time T = the cut-off moment T2 - the initial moment T1.

Further, the step of causing the state of charge of the energy storage battery to reach the first preset value includes: powering on the energy storage system; judging whether the state of charge of the energy storage battery is less than or equal to the first preset value, if so, executing a judgement step of judging whether the state of charge of the energy storage battery is equal to the first preset value, if not, executing a step of discharging the energy storage battery, and executing a step of judging whether the state of charge of the energy storage battery is less than or equal to the first preset value after performing discharging for a period of time.

Further, the step of causing the state of charge of the energy storage battery to reach the first preset value further includes: judging whether the state of charge of the energy storage battery is equal to the first preset value, if so, executing the discharge time acquisition step, if not, executing the step of charging the energy storage battery, and executing a step of judging whether the state of charge of the energy storage battery is equal to the first preset value after performing charging for a period of time.

Further, before the discharge time acquisition step, and after the step of causing the state of charge of the energy storage battery to reach the first preset value, the active fault detection method of the energy storage system further includes: issuing a standby instruction to an energy storage converter by a micro-grid controller; disconnecting and controlling an electric connection between the energy storage battery and a micro-grid; and sequentially connecting the energy storage battery, the energy storage converter and a load end to end, so as to form a test loop.

Further, after the step of judging that the energy storage battery is normal, the active fault detection method of the energy storage system further includes: issuing the standby instruction to the energy storage converter by the micro-grid controller; controlling the test loop to be disconnected by using the micro-grid controller; and electrically connecting the energy storage battery with the micro-grid by using the micro-grid controller.

Further, after the step of judging that the energy storage battery is normal, the active fault detection method of the energy storage system further includes: a periodic inspection and judgement step of judging whether the difference between a current moment and a previous detection end moment is greater than or equal to a detection period, if so, executing the step of causing the state of charge of the energy storage battery to reach the first preset value, if not, delaying for a preset time, and then executing the periodic inspection and judgement step.

According to another aspect of the present invention, some embodiments of the present invention provide an energy storage system, wherein a fault is detected by using the above active fault detection method of the energy storage system, the energy storage system includes: an energy storage converter, the energy storage battery, a load and a first switch, which are electrically connected end to end in sequence, so as to form a test loop for detecting whether the energy storage battery has a fault, the energy storage converter is configured to perform AC/DC conversion with a power grid and perform charging and discharging power control on the energy storage battery, and the first switch is configured to form a control connection with a micro-grid controller, so as to control whether to turn on the test loop; and the energy storage system further includes the micro-grid controller and a second switch in control connection with the micro-grid controller, the second switch is located between the energy storage converter and a micro-grid, and the energy storage converter and the first switch are both in control connection with the micro-grid controller.

Further, the energy storage system further includes a battery management system in control connection with the energy storage battery, the micro-grid controller is in control connection with the battery management system, and the battery management system is configured to collect a voltage Vi of each battery cell i.

By applying the technical solutions of the present invention, the energy storage converter (PCS) and the second switch are controlled by the micro-grid controller, so that the energy storage battery can be separated from the micro-grid, so as to avoid affecting an operation of the micro-grid when fault detection is performed on the energy storage battery; and moreover, the load connected in series with the energy storage battery is further disclosed on the test loop, and the load is used for consuming the power during the test of the energy storage system, so as to provide a test condition for the test of the energy storage system, the micro-grid controller may cause the energy storage battery to communicate with the load by turning on the first switch, so as to form an independent test loop, then the micro-grid controller controls the energy storage battery to perform charging and discharging via the energy storage converter, and a fault is detected by using the following active fault detection method of the energy storage system during the charging and discharging of the energy storage battery. In this way, not only can the fault of the energy storage battery be effectively detected, but the influence on the operation of the micro-grid can also be avoided.

### Brief Description of the Drawings

The drawings, which constitute a part of the present invention, are used to provide a further understanding of the present invention, and illustrative embodiments of the present invention and descriptions thereof are used to explain the present invention, and do not constitute improper limitations to the present invention. In the drawings:
Fig. 1 illustrates one flowchart of an embodiment of an active fault detection method of an energy storage system according to the present invention;
Fig. 2 illustrates another flowchart of an embodiment of an active fault detection method of an energy storage system according to the present invention; and
Fig. 3 illustrates schematic structural diagram of an embodiment of an energy storage system according to the present invention.

### Detailed Description of the Embodiments

It should be noted that in the case of no conflict, embodiments in the present invention and features in the embodiments may be combined with each other. The present invention will be described in detail below with reference to the drawings and in combination with the embodiments.

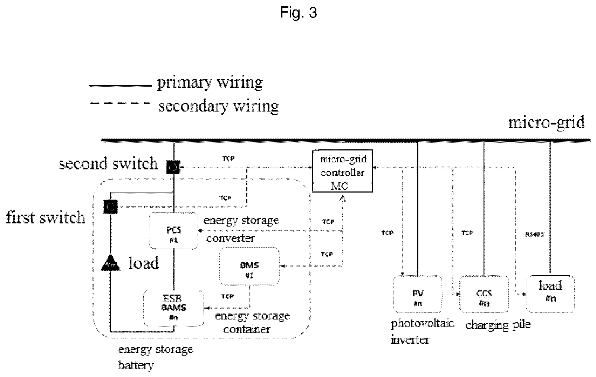

As shown in Fig. 3, an embodiment of the present invention provides an energy storage system, which detects a fault by using an active fault detection method of the energy storage system below. The energy storage system includes: an energy storage converter, an energy storage battery, a load and a first switch, which are electrically connected end to end in sequence, so as to form a test loop for detecting whether the energy storage battery has a fault, wherein the energy storage converter is configured to perform AC/DC conversion with a power grid and perform charging and discharging power control on the energy storage battery, and the first switch is configured to form a control connection with a micro-grid controller, so as to control whether to turn on the test loop; and the energy storage system further includes the micro-grid controller and a second switch in control connection with the micro-grid controller, the second switch is located between the energy storage converter and a micro-grid, and the first switch and the energy storage converter are both in control connection with the micro-grid controller.

**In** the above technical solution, the energy storage converter (PCS) and the second switch are controlled by the micro-grid controller, so that the energy storage battery is separated from the micro-grid, so as to avoid affecting the operation of the micro-grid when fault detection is performed on the energy storage battery; and moreover, the load connected in series with the energy storage battery is further disclosed on the test loop, and the load is used for consuming the power during the test of the energy storage system, so as to provide a test condition for the test of the energy storage system, the micro-grid controller may cause the energy storage battery to communicate with the load by turning on the first switch, so as to form an independent test loop, then the micro-grid controller controls the energy storage battery to perform charging and discharging via the energy storage converter, and a fault is detected by using the following active fault detection method of the energy storage system during the charging and discharging of the energy storage battery. In this way, not only can the fault of the energy storage battery be effectively detected, but the influence on the operation of the micro-grid can also be avoided.

Further, fault detection is performed by using the above energy storage system, by means of a coordination control of the micro-grid controller, the energy storage system automatically tests the fault, and the energy storage system automatically separates from the micro-grid safely and then enters the test loop, thereby improving the test convenience of the energy storage system, and there is no need to manually connect the test loop onsite to test the energy storage battery, thereby solving the problem of it being difficult to test the energy storage system on a project site.

**In** the embodiment of the present invention, both the first switch and the second switch are circuit breakers.

**In** some embodiments of the present invention, the load must have the capability of supporting at least 4C discharging of the energy storage battery.

**In** some embodiments of the present invention, a battery management system utilizes an STM32F4 series micro-controller, and the micro-grid controller utilizes an ARM-A53 controller.

As shown in Fig. 3, in the embodiment of the present invention, the energy storage system further includes a battery management system (BMS) in control connection with the energy storage battery, the micro-grid controller is in control connection with the battery management system, and the battery management system is configured to collect a voltage Vi of each battery cell i.

By the above settings, the battery management system acquires the voltage Vi of the each battery cell i, and transmit the acquired data to the micro-grid controller, so that the micro-grid controller analyzes and processes the voltage data so as to issue a control instruction to protect the energy storage battery.

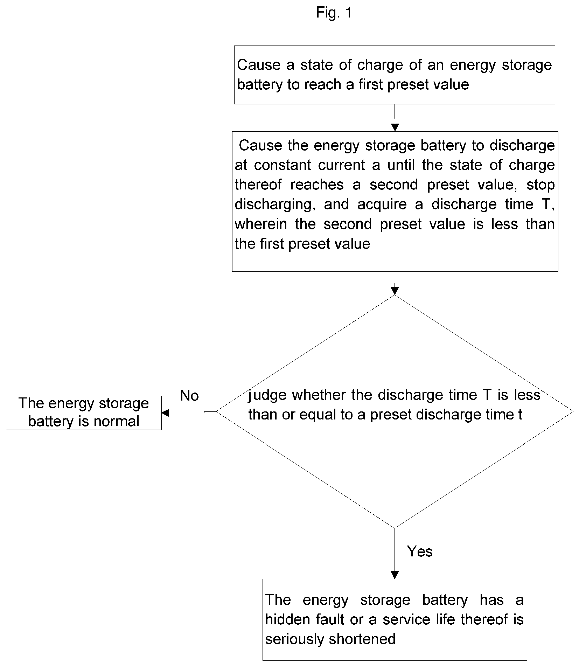

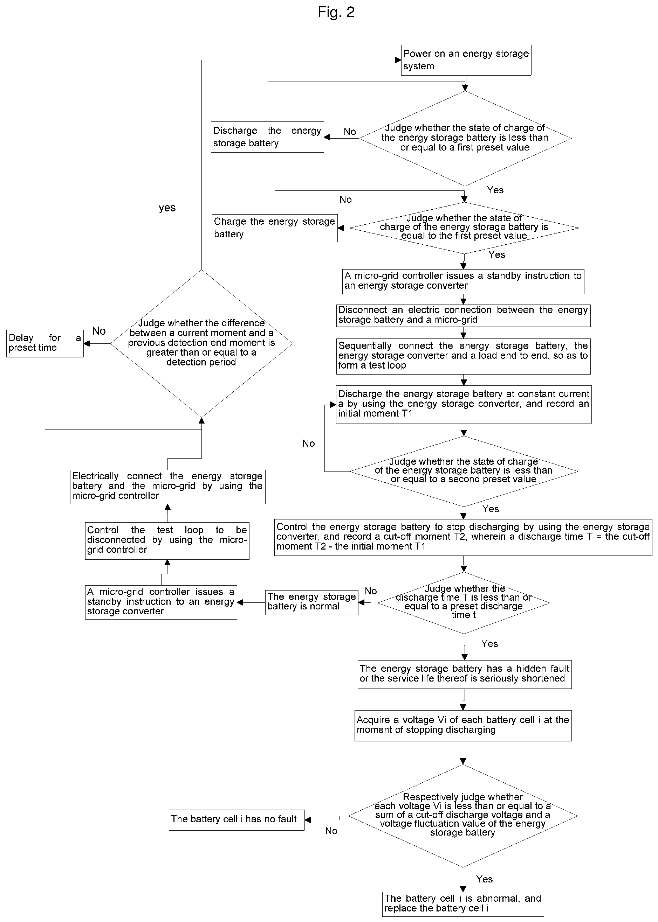

As shown in Fig. 1 and Fig. 2, an embodiment of the present invention provides an active fault detection method of the energy storage system. The above energy storage system is used for detection. The active fault detection method of the energy storage system includes: a step of causing a state of charge of the energy storage battery to reach a first preset value; a discharge time acquisition step of causing the energy storage battery to discharge at constant current a until the state of charge thereof reaches a second preset value, stopping discharging, and acquiring a discharge time T, wherein the second preset value is less than the first preset value; and judging whether the discharge time T is less than or equal to a preset discharge time t, if so, judging that the energy storage battery has a hidden fault or the service life of the energy storage battery is seriously shortened, and if not, judging that the energy storage battery is normal.

In the above technical solution, by causing the energy storage battery to discharge at the constant current a and judging whether the discharge time T of the energy storage battery meets the requirement (i.e., comparing the discharge time T of the energy storage battery with the preset discharge time t), a discharge capability of the energy storage battery is detected, so as to judge whether the energy storage battery has the hidden fault or whether the service life thereof is seriously shortened, and whether the battery cells in the energy storage battery have better consistency may also be effectively checked.

In some embodiments, if the discharge time T is less than or equal to the preset discharge time t, it indicates that the consistency of a plurality of battery cells of the energy storage battery is poor, there is a case where a certain battery cell reaches a cut-off discharge voltage in advance, therefore judgment can be further performed to screen out an abnormal battery cell.

It should be noted that, in the embodiment of the present invention, the discharge current a is greater than or equal to 2C, (wherein C is a battery charging and discharging capability rate, which is a measure for indicating a discharge speed, and 1C refers to the magnitude of current after the total capacity of the battery is discharged within 1 hour), so that the energy storage battery can be caused to discharge at large current.

It should be noted that, in the embodiment of the present invention, the first preset value and the second preset value are empirical values. When energy storage is performed in the case of low capacity of the battery, the difference between the battery cells of the energy storage battery is relatively obvious, and the influence of a faulty battery cell (the abnormal battery cell causing a hidden fault of the energy storage battery) on an output power of the energy storage battery is more obvious, in this way, the first preset value and the second preset value are selected according to the above cases, in some embodiments, the first preset value is 30%, and the second preset value is 20%. In this way, large-current discharge can be performed on the energy storage battery at a low capacity to quickly check the continuous power output capability of the energy storage battery, so as to check the overall performance of the energy storage battery to discover the hidden fault of the energy storage battery.

The first preset value is greater than a discharge cut-off capacity of the energy storage battery (during discharging, when the capacity of the energy storage battery reaches the discharge cut-off capacity, the energy storage battery stops discharging).

In one embodiment, the first preset value may also be a value greater than 30%, even if the energy storage battery is not at a low capacity, when the energy storage battery is discharged, the faulty battery cell may also affect the output power of the energy storage battery, in this way, it is also possible to judge whether the energy storage battery has a hidden fault.

It should be noted that, in the embodiment of the present invention, the preset discharge time t is an empirical value obtained by performing a large number of charging and discharging tests on a normal battery cell, for example, a difference value between the first preset value and the second preset value is 10%, and discharge is performed at a discharge rate of 2C, then t is 0.04 h.

It should be noted that, in the embodiment of the present invention, the hidden fault refers to a fault in which the majority of batteries have the problems of poor welding or poor battery manufacturing process inside or outside at the beginning of production or after running for a period of time, for example, external insufficient welding or an internal fault of a single battery, the energy storage system may still normally operate in the presence of the above fault under conventional charging and discharging conditions (constant-current charging and discharging), that is, the fault is difficult to appear (i.e., the energy storage battery has the hidden fault), and the fault is prominent after vibration such as transportation over a period of time, or operation.

It should be noted that, in the embodiment of the present invention, the service life of the energy storage battery is seriously shortened means that the service life of the energy storage battery is less than 80% of the initial service life.

As shown in Fig. 2, in the embodiment of the present invention, the energy storage battery includes a plurality of battery cells, the serial number of each of the plurality of battery cells is i, i may be 1 to n, n is an integer greater than 1, and after judging that the energy storage battery has the hidden fault or the service life thereof is seriously shortened, the active fault detection method of the energy storage system further includes: acquiring a voltage Vi of the each of the plurality of battery cells i at the moment of stopping discharging; respectively judging whether the voltage Vi is less than or equal to a sum of a cut-off discharge voltage and a voltage fluctuation value of the energy storage battery, if so, judging that the battery cell i is abnormal and replacing the battery cell i, and if not, judging that the battery cell i has no fault.

By means of the above settings, a problem battery cell approaching to the cut-off discharge voltage first among all battery cells can be recognized, and the problem battery cell is screened out for replacement, thereby achieving the purpose of eliminating the abnormal battery cell, in this way, the service life of the energy storage system is effectively prolonged, a battery cell fault of the energy storage battery during daily operation is effectively avoided, and the safety performance and a health index of the energy storage system are improved.

It should be noted that, in the embodiment of the present invention, the cut-off discharge voltage of the battery is related to a battery type, a voltage grade and the like, a lithium battery is used in the present embodiment, and the cut-off discharge voltage thereof is 3.2 V.

It should be noted that, in the embodiment of the present invention, the voltage fluctuation value is set to be 0.2 V, in this way, an abnormal battery cell approaching to the cut-off discharge voltage can be recognized, and the voltage of the battery cell can be prevented from falling to the cut-off discharge voltage.

Specifically, in the embodiment of the present invention, a battery management system is used to acquire the voltage Vi of each battery cell i at the moment of stopping discharging.

As shown in Fig. 2, in the embodiment of the present invention, the discharge time acquisition step includes: a discharging step of discharging the energy storage battery at a constant current a by using an energy storage converter, and recording an initial moment T1; and judging whether a state of charge of the energy storage battery is less than or equal to the second preset value, if so, controlling the energy storage battery to stop discharging by using the energy storage converter and recording a cut-off moment T2, and if not, continuing to execute the discharging step, wherein the discharge time T = the cut-off moment T2 - the initial moment T1. In this way, the discharge time T of the energy storage battery from starting discharging at the first preset value to discharging to the second preset value can be obtained to conveniently judge whether the discharge time T of the energy storage battery meets the requirement, thereby improving the detection accuracy.

As shown in Fig. 2, in the embodiment of the present invention, the step of causing the state of charge of the energy storage battery to reach the first preset value includes: powering on the energy storage system; judging whether the state of charge of the energy storage battery is less than or equal to the first preset value, if so, executing a judgement step of judging whether the state of charge of the energy storage battery is equal to the first preset value, if not, executing the step of discharging the energy storage battery, and executing the step of judging whether the state of charge of the energy storage battery is less than or equal to the first preset value after performing discharging for a period of time.

By means of the above settings, the state of charge (SOC) of the energy storage battery can reach the first preset value or below the first preset value, so that the energy storage battery can start discharging at the first preset value subsequently, thereby improving the detection accuracy.

It should be noted that, in the embodiment of the present invention, powering on the energy storage system refers to activating the energy storage system, so that the battery management system, the energy storage converter and the micro-grid controller are powered on.

It should be noted that, in the embodiment of the present invention, discharging for the period of time mentioned above is a preset value, which may be 1 second or 2 seconds, or 1 minute, etc.

After the energy storage system is powered on, the active fault detection method of the energy storage system further includes: detecting, by using the micro-grid controller, whether the energy storage system has a significant operation fault, that is, whether the energy storage system operates normally, if the energy storage system may operate normally, executing the step of judging whether the state of charge of the energy storage battery reaches the first preset value, and if the energy storage system cannot operate normally, the energy storage system has a potential safety hazard and cannot perform an active detection mode. In this way, the safety of the energy storage system can be ensured.

As shown in Fig. 2, in the embodiment of the present invention, the step of causing the state of charge of the energy storage battery to reach the first preset value further includes: judging whether the state of charge of the energy storage battery is equal to the first preset value, if so, executing the discharge time acquisition step, if not, performing charging on the energy storage battery, and executing the step of judging whether the state of charge of the energy storage battery is equal to the first preset value after performing charging for a period of time, until the state of charge of the energy storage battery reaches the first preset value.

By means of the above settings, the state of charge (SOC) of the energy storage battery can reach the first preset value, so that the energy storage battery can start discharging at the first preset value subsequently, thereby improving the detection accuracy.

It should be noted that, in the embodiment of the present invention, charging for the period of time mentioned above is a preset value, which may be 1 second or 2 seconds, or 1 minute, etc.

As shown in Fig. 2, in the embodiment of the present invention, before the discharge time acquisition step, and after the step of causing the state of charge of the energy storage battery to reach the first preset value, the active fault detection method of the energy storage system further includes: issuing a standby instruction to an energy storage converter by the micro-grid controller; disconnecting and controlling an electric connection between the energy storage battery and a micro-grid; and sequentially connecting the energy storage battery, the energy storage converter and a load end to end, so as to form a test loop.

In the above technical solution, the micro-grid controller issues the standby instruction to the energy storage converter, in this way, the energy storage battery can stop charging and discharging, thereby avoiding affecting subsequent works; then, the electric connection between the energy storage battery and the micro-grid is disconnected by using the second switch, so that the energy storage system is completely disconnected from the power grid, thereby avoiding the generation of large impact current, and thus avoiding the influence of subsequent tests on the operation of the micro-grid or avoiding the influence of the micro-grid on subsequent tests; and finally, the first switch is turned on to connect the energy storage battery, the energy storage converter and the load end to end to form the test loop, wherein the load can be used for consuming the power of the energy storage system during testing, so as to provide a test condition for the test of the energy storage system.

In one embodiment, the load and the energy storage battery may also be manually connected onsite to form the test loop, so as to test the energy storage battery.

As shown in Fig. 2, in the embodiment of the present invention, after the step of judging that the energy storage battery is normal, the active fault detection method of the energy storage system further includes: issuing the standby instruction to the energy storage converter by the micro-grid controller; controlling the test loop to be disconnected by using the micro-grid controller; and electrically connecting the energy storage battery with the micro-grid by using the micro-grid controller.

In the above technical solution, after it is judged that the energy storage battery is normal, the micro-grid controller issues the standby instruction to the energy storage converter, so that the energy storage battery stops charging and discharging, the micro-grid controller controls the first switch to be disconnected to disconnect the load from the energy storage battery, and then the micro-grid controller controls the second switch to be turned on, so that the energy storage battery is connected to the micro-grid, and thus the energy storage system continues to work.

As shown in Fig. 2, in the embodiment of the present invention, after the step of judging that the energy storage battery is normal, the active fault detection method of the energy storage system further includes: a periodic inspection and judgement step of judging whether a difference between a current moment and a previous detection end moment is greater than or equal to a detection period, if so, executing the step of causing the state of charge of the energy storage battery to reach the first preset value, if not, delaying for a preset time, and then executing the periodic inspection and judgement step.

In the above technical solution, by setting a fixed detection period, during normal operation of the energy storage system, fault diagnosis is periodically performed on the energy storage system to initiatively discover whether there is a hidden fault in the energy storage system and to screen out an abnormal battery cell for replacement, thereby avoiding the problem of a fault of the entire system caused by the fault of a single battery cell, and thus improving the operation safety and stability of the energy storage system, and realizing unmanned management.

It should be noted that, in the embodiment of the present invention, the detection period is a manual set value, which may be one year or one month or one week.

In one embodiment, a diagnosis instruction may also be manually issued by a software operator to enter a diagnosis mode.

It should be noted that, in the embodiment of the present invention, the previous detection end moment refers to a moment at which the energy storage battery is judged to be normal during the previous detection.

In the present embodiment, the service life of the energy storage system is prolonged by periodically inspecting and manually replacing the abnormal battery cell, and the occurrence of a battery cell fault during the normal operation of the energy storage system can also be avoided.

It should be noted that, the micro-grid controller performs unified scheduling, collection and analysis without manual intervention, so that the manual operation and maintenance cost is greatly reduced, autonomous fault detection of the energy storage system is realized, and the overall safety and intelligence level of the energy storage system is improved.

From the above descriptions, it can be seen that the above embodiments of the present invention achieve the following technical effects: the energy storage converter (PCS) and the second switch are controlled by the micro-grid controller, so that the energy storage battery can be separated from the micro-grid, so as to avoid affecting the operation of the micro-grid when fault detection is performed on the energy storage battery; and moreover, the load connected in series with the energy storage battery is further disclosed on the test loop, and the load may be used for consuming the power during the test of the energy storage system, so as to provide a test condition for the test of the energy storage system, the micro-grid controller may cause the energy storage battery to communicate with the load by turning on the first switch, so as to form an independent test loop, then the micro-grid controller controls the energy storage battery to perform charging and discharging by the energy storage converter, and a fault is detected by using the above active fault detection method of the energy storage system during the charging and discharging of the energy storage battery. In this way, not only can the fault of the energy storage battery be effectively detected, but the influence on the operation of the micro-grid can also be prevented.

The above descriptions are only some embodiments of the present invention and are not intended to limit the present invention, and for those skilled in the art, the present invention may have various modifications and changes. Any modifications, equivalent replacements, improvements, and the like, made within the spirit and principles of the present invention, shall fall within the protection scope of the present invention.

## Claims

1. An active fault detection method of an energy storage system, comprising:
a step of causing a state of charge of an energy storage battery to reach a first preset value;
a discharge time acquisition step of causing the energy storage battery to discharge at constant current a until the state of charge thereof reaches a second preset value, stopping discharging, and acquiring a discharge time T, wherein the second preset value is less than the first preset value; and
judging whether the discharge time T is less than or equal to a preset discharge time t, if so, judging that the energy storage battery has a hidden fault or a service life thereof is seriously shortened, and if not, judging that the energy storage battery is normal.

2. The active fault detection method of the energy storage system according to claim 1, wherein the energy storage battery comprises a plurality of battery cells, a serial number of each of the plurality of battery cells is i, i may be 1 to n, n is an integer greater than 1, and the active fault detection method of the energy storage system further comprises: after judging that the energy storage battery has the hidden fault or the service life thereof is seriously shortened,
acquiring a voltage Vi of the each of the plurality of battery cells i at a moment of stopping discharging;
respectively judging whether each voltage Vi is less than or equal to a sum of a cut-off discharge voltage and a voltage fluctuation value of the energy storage battery, if so, judging that a battery cell i in the plurality of battery cells is abnormal and replacing the battery cell i, and if not, judging that the battery cell i has no fault.

3. The active fault detection method of the energy storage system according to claim 1, wherein the discharge time acquisition step comprises:
a discharging step of discharging the energy storage battery at the constant current a by using an energy storage converter, and recording an initial moment T1; and
judging whether the state of charge of the energy storage battery is less than or equal to the second preset value, if so, controlling the energy storage battery to stop discharging by using the energy storage converter and recording a cut-off moment T2, and if not, continuing to execute the discharging step, wherein the discharge time T = the cut-off moment T2 - the initial moment T1.

4. The active fault detection method of the energy storage system according to claim 1, wherein the step of causing the state of charge of the energy storage battery to reach the first preset value comprises:
powering on the energy storage system;
judging whether the state of charge of the energy storage battery is less than or equal to the first preset value, if so, executing a judgement step of judging whether the state of charge of the energy storage battery is equal to the first preset value, if not, executing a step of discharging the energy storage battery, and executing a step of judging whether the state of charge of the energy storage battery is less than or equal to the first preset value after performing discharging for a period of time.

5. The active fault detection method of the energy storage system according to claim 4, wherein the step of causing the state of charge of the energy storage battery to reach the first preset value further comprises:
judging whether the state of charge of the energy storage battery is equal to the first preset value, if so, executing the discharge time acquisition step, if not, executing the step of charging the energy storage battery, and executing a step of judging whether the state of charge of the energy storage battery is equal to the first preset value after performing charging for a period of time.

6. The active fault detection method of the energy storage system according to any one of claims 1-5, wherein before the discharge time acquisition step, and after the step of causing the state of charge of the energy storage battery to reach the first preset value, the active fault detection method of the energy storage system further comprises:
issuing a standby instruction to an energy storage converter by a micro-grid controller;
disconnecting and controlling an electric connection between the energy storage battery and a micro-grid; and
sequentially connecting the energy storage battery, the energy storage converter and a load end to end, so as to form a test loop.

7. The active fault detection method of the energy storage system according to claim 6, wherein after the step of judging that the energy storage battery is normal, the active fault detection method of the energy storage system further comprises:
issuing the standby instruction to the energy storage converter by the micro-grid controller;
controlling the test loop to be disconnected by using the micro-grid controller; and
electrically connecting the energy storage battery with the micro-grid by using the micro-grid controller.

8. The active fault detection method of the energy storage system according to any one of claims 1-5, wherein after the step of judging that the energy storage battery is normal, the active fault detection method of the energy storage system further comprises:
a periodic inspection and judgement step of judging whether a difference between a current moment and a previous detection end moment is greater than or equal to a detection period, if so, executing the step of causing the state of charge of the energy storage battery to reach the first preset value, if not, delaying for a preset time, and then executing the periodic inspection and judgement step.

9. An energy storage system, wherein a fault is detected by using the active fault detection method of the energy storage system according to any one of claims 1-8, and the energy storage system comprises:
an energy storage converter, the energy storage battery, a load and a first switch, which are electrically connected end to end in sequence, so as to form a test loop for detecting whether the energy storage battery has a fault, the energy storage converter is configured to perform AC/DC conversion with a power grid and perform charging and discharging power control on the energy storage battery, and the first switch is configured to form a control connection with a micro-grid controller, so as to control whether to turn on the test loop; and
the energy storage system further comprises the micro-grid controller and a second switch in control connection with the micro-grid controller, the second switch is located between the energy storage converter and a micro-grid, and the energy storage converter and the first switch are both in control connection with the micro-grid controller.

10. The active fault detection method of the energy storage system according to claim 9, wherein the energy storage system further comprises a battery management system in control connection with the energy storage battery, the micro-grid controller is in control connection with the battery management system, and the battery management system is configured to collect a voltage Vi of each battery cell i.
